# EUROPEAN PATENT SPECIFICATION

(11) **EP 3 430 627 B1**
(45) Date of publication and mention of the grant of the patent: **12.01.2022**
(21) Application number: 16894745.5
(22) Date of filing: 16.03.2016
(51) Int. Cl.: G11C 29/02, G11C 29/04, G01R 31/3185, G11C 29/14, G11C 29/46, G01R 31/317

(54) **CONTROLLING A TRANSITION BETWEEN A FUNCTIONAL MODE AND A TEST MODE**
STEUERUNG EINES ÜBERGANGS ZWISCHEN EINEM FUNKTIONSMODUS UND PRÜFMODUS
COMMANDE D'UNE TRANSITION ENTRE UN MODE FONCTIONNEL ET UN MODE DE TEST

(43) Date of publication of application: 23.01.2019
(73) Proprietor: Hewlett-Packard Development Company, L.P., Spring TX 77389 (US)
(72) Inventor: MCWILLIAMS, John L., San Diego, California 92127-1899 (US)
(74) Representative: Haseltine Lake Kempner LLP
(86) International application number: PCT/US2016/022640
(87) International publication number: WO 2017/160286

(56) References cited:
- EP-A1- 1 439 398
- US-A1- 2002 162 065
- US-A1- 2005 138 500
- US-A1- 2005 228 616
- US-A1- 2007 300 108
- US-A1- 2008 320 347
- US-A1- 2009 172 819
- US-A1- 2009 307 411
- US-A1- 2011 246 844

## Description

### Background

A logic chip can include various circuitry to provide respective functionalities. Examples of logic chips include integrated circuit (IC) chips. A logic chip can be operated in a test mode, which can be used to test functionalities of different parts of the logic chip. US 2009/172819 A1 relates to a method and apparatus for implementing a logic security feature. US 2002/162065 A1 relates to a scan test circuit.

### Brief Description Of The Drawings

Some implementations of the present disclosure are described with respect to the following figures.
Fig. 1 is a block diagram of a logic chip including a test mode transition control circuit according to some examples.
Fig. 2 is a block diagram of a test mode transition control circuit according to some examples.
Fig. 3 is a block diagram of components of a test mode input circuit and a test mode transition control circuit, according to further examples.
Figs. 4A and 4B are flow diagrams of processes of controlling a transition between a functional mode and a test mode of a logic chip, according to some examples.

### Detailed Description

A logic chip can refer to any arrangement of circuitry that can be provided on a substrate, such as a semiconductor die, a circuit board, or any other support structure on which circuitry can be formed. The circuitry that can be included in a logic chip can include transistors, storage elements, and various other electronic elements that can be interconnected to provide respective functionalities. The logic chip also includes communication lines to interconnect the elements, where the communication lines can be implemented using electrically conductive traces or optical links.

Examples of logic chips can include integrated circuit (IC) chips such as a microprocessor, a microcontroller, a memory device, a programmable gate array, a programmable integrated circuit, or any other type of electronic device.

A logic chip can be provided with a test mode, sometimes referred to as a design for testability (DFT) mode. When the logic chip is placed into the test mode, various test operations can be run with respect to the logic chip, to test various features of the logic chip. In some examples, during test mode, storage elements (such as registers or other types of storage elements) can be accessed as part of test operations.

In some examples, the storage elements that are accessed during the test mode can be designated for storing sensitive information during a functional mode of the logic chip. The functional mode of the logic chip is a mode of the logic chip during normal use of the logic chip, such as when the logic chip is incorporated into a larger system such as a computer, a smart phone, a game appliance, a vehicle, a wearable device (e.g. smart watch, smart eyeglasses, etc.), and so forth. The functional mode can also be referred to as a non-test mode.

During the functional mode of the logic chip, sensitive information can be stored into one or multiple storage elements, such as a register. Sensitive information stored in a storage element can refer to any information that is intended to only be accessed by authorized entities, such as any or some combination of the following: authorized firmware, software, or other machine-readable instructions, authorized hardware devices, or authorized users. Examples of sensitive information can include cryptographic information (such as a key that is used to perform encryption and/or decryption of data), where the cryptographic information can be used to protect other data from unauthorized access. Other examples of sensitive information can include information that is confidential or proprietary to a particular enterprise or user.

The test mode can be used by a manufacturer of the logic chip to confirm proper operation of the logic chip during the manufacture stage of the logic chip. In other examples, the test mode of the logic chip can be invoked at other times, such as when repair or debugging is desired. After testing is performed, the logic chip can be transitioned from the test mode to the functional mode.

The presence of the test mode in a logic chip can present a potential security hole that can be exploited by a hacker to gain access to sensitive information stored in a storage element in the logic chip. The sensitive information is stored in the storage element during the functional mode of the logic chip. After the logic chip has been placed into the functional mode and after some sensitive information has been stored into the storage elements of the logic chip, a hacker can switch the logic chip to the test mode, to gain access to the sensitive information in the storage element.

In accordance with some implementations of the present disclosure, a test mode transition control circuit is provided to control the transition between a functional mode of a logic chip and a test mode of the logic chip, to prevent unauthorized access of sensitive information stored in a storage element in the logic chip. The test mode transition control circuit restricts the transition from the functional mode to the test mode until a specific condition is satisfied (e.g. the logic chip 100 is reset or some other condition that indicates that sensitive information stored in the logic chip 100 has been rendered inaccessible).

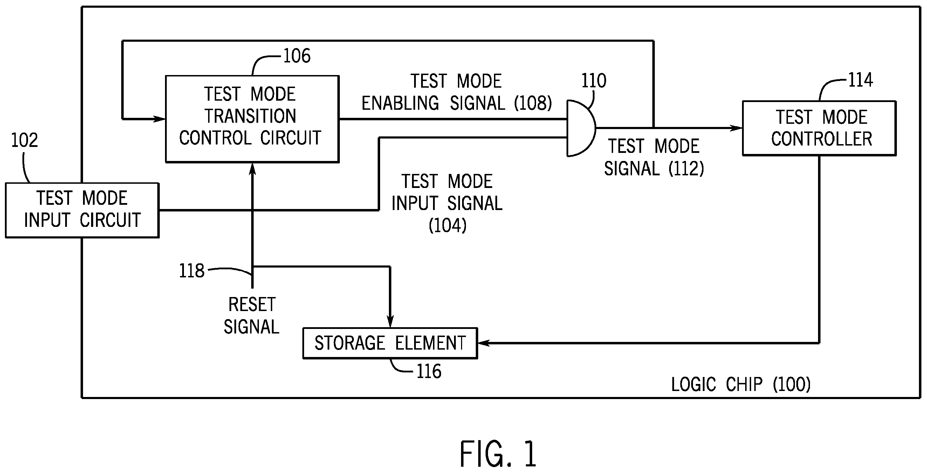

Fig. 1 is a block diagram of an example logic chip 100, which includes a test mode input circuit 102 to receive an input indicating that activation of the test mode of the logic chip 100 is requested. In some examples, the test mode input circuit 102 can include an input pin or multiple input pins, where the pin(s) can be coupled to an external pad (or pads). The external pad(s) can be set to a predefined value to indicate that test mode is requested. In other examples, the input pin(s) of the test mode input circuit 102 can be coupled to the output of a controller or other device, where the controller or other device can set the input pin(s) to the predefined value to request entry of the logic chip 100 into the test mode.

When the input pin(s) of the test mode input circuit 102 is (are) set to the predefined value indicating that test mode is requested, then the test mode input circuit 102 activates a test mode input signal 104, where the activation of the test mode input signal 104 is an indication that test mode is requested. Activation of a signal can refer to setting the signal to an active state (which can be a logic high or logic low state). Deactivation of a signal can refer to setting the signal to an inactive state (which can be a logic low or logic high state). If the input pin(s) of the test mode input circuit 102 is (are) set to the predefined value, then the test mode input signal 104 is set to the active state (i.e. activated). On the other hand, if the input pin(s) of the test mode input circuit is (are) not set to the predefined value, then the test mode input signal 104 is set to the inactive state (i.e. deactivated).

In accordance with some implementations of the present disclosure, the logic chip 100 also includes a test mode transition control circuit 106, which outputs a test mode enabling signal 108. Generally, while the logic chip 100 is in the functional mode, the test mode transition control circuit 106 deactivates the test mode enabling signal 108 to prevent the logic chip 100 from transitioning from the functional mode to the test mode. However, when a specified condition occurs (e.g. the logic chip 100 is reset by activation of a reset signal 118, or some other condition occurs that indicates that sensitive information in the logic chip 100 has been rendered inaccessible), the test mode transition control circuit 106 activates the test mode enabling signal 108 to allow the logic chip 100 to transition from the functional mode to the test mode, in response to a request received at the test mode input circuit 102 to transition the logic chip 100 to the test mode.

In some examples, the test mode enabling signal 108 is provided to a first input of an AND logic gate 110, while the test mode input signal 104 is provided to another input of the logic AND gate 110. The logic AND gate 110 is to activate a test mode signal 112 if both its inputs are in an active state. If either or both of the inputs to the logic AND gate 110 is (are) inactive, then the logic AND gate 110 deactivates the test mode signal 112.

The test mode signal 112 when in the active state specifies that the logic chip 100 is in the test mode. On the other hand, the test mode signal 112 when in the inactive state specifies that the logic chip 100 is in the functional mode.

In other examples, instead of being a logic AND gate, the gate 110 can be a logic combination gate (including a combination of logic circuitry) that activates the test mode signal 112 only when both the test mode enabling signal 108 and the test mode input signal 104 are active.

Effectively, when the test mode transition control circuit 106 deactivates the test mode enabling signal 108, the test mode signal 112 remains deactivated even if the test mode input signal 104 is activated by the test mode input circuit 102. The test mode enabling signal 108 when inactive causes the logic chip 100 to ignore the test mode input signal 104.

The test mode signal 112 is provided as an input to a test mode controller 114. The test mode controller 114 can be a hardware processing circuit, or a combination of the hardware processing circuit and machine-readable instructions (software or firmware) executable on the hardware processing circuit. A hardware processing circuit can include a microprocessor, a core of a multi-core microprocessor, a microcontroller, a programmable gate array, a programmable integrated circuit, and so forth.

When the test mode signal 112 is activated, the test mode controller 114 is able to perform test operations to test respective features of the logic chip 100. The test operations can include accessing information stored in a storage element 116 in the logic chip 100. In some examples, the storage element 116 can include a register. In other examples, other types of storage elements can be included in the logic chip 100, where such other storage elements can also be accessed by the test mode controller 114 during a test operation in the test mode. The storage element 116 can be used to store sensitive information during operation of the logic chip 100 in the functional mode.

In accordance with some implementations of the present disclosure, while the logic chip 100 is in the functional mode, the test mode transition control circuit 106 maintains the test mode enabling signal 108 in an inactive state, to prevent activation of the test mode signal 112 even if the test mode input circuit 102 asserts the test mode input signal 104 to an active state. This effectively prevents the logic chip 100 from transitioning from the functional mode to the test mode. Thus, even if a hacker were to set the input pin(s) of the test mode input circuit 102 to the predefined value for requesting that the logic chip 100 enter the test mode, the test mode transition control circuit 106 would prevent the logic chip 100 from transitioning to the test mode, which would prevent the hacker from accessing sensitive information that may be stored in the storage element 116.

To allow the logic chip 100 to transition to the test mode, the logic chip 100 has to be first reset (or another condition has to occur that indicates that sensitive information has been rendered inaccessible, such as by clearing the sensitive information). A reset of the logic chip 100 is caused by activation of the reset signal 118. The reset signal 118 is provided as input to both the test mode transition control circuit 106 and the storage element 116. The reset signal 118 clears the storage element 116, such that any information (which can include sensitive information) stored in the storage element 116 is deleted, and thus, rendered inaccessible.

The reset signal 118 when activated also causes the test mode transition control circuit 106 to activate the test mode enabling signal 108. Activating the test mode enabling signal 108 allows the logic AND gate 110 to activate the test mode signal 104 in response to activation of the test mode input signal 104. Activating the test mode signal 104 causes transition of the logic chip 100 from the functional mode to the test mode.

To transition the logic chip 100 from the test mode to the functional mode, the input pin(s) of the test mode input circuit 102 can be set to a value that indicates that the logic chip 100 is not to be placed in the test mode. As a result, the test mode input circuit 102 deactivates the test mode input signal 104, which causes deactivation of the test mode signal 112 by the logic AND gate 110 to place the logic chip 100 in the functional mode.

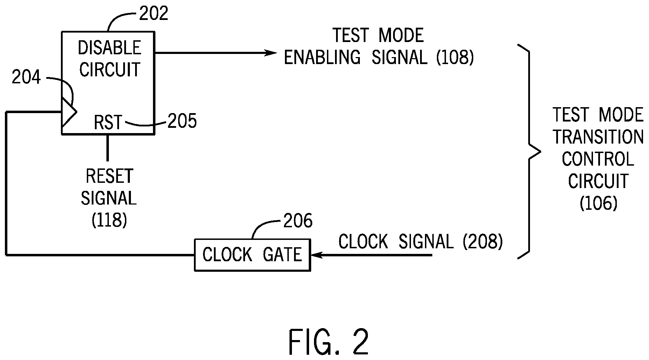

Fig. 2 is a block diagram of the test mode transition control circuit 106 according to some examples of the present disclosure. The test mode transition control circuit 106 includes a disable circuit 202 that has a clock input 204 and a reset input 205. The disable circuit 202 outputs the test mode enabling signal 108.

The clock input 104 of the disable circuit 202 is to receive a clock signal, which in Fig. 2 is a clock signal 208 that is passed through a clock gate 206. The clock gate 206 passes the clock signal 208 to the clock input 204 of the disable circuit 202 in response to the logic chip 100 being in the functional mode. When the clock input 204 of the disable circuit 202 receives an active clock signal 208 and reset signal 118 is inactive, then the disable circuit 202 is able to perform its specified functionality of deactivating the test mode enabling signal 108. In some examples, in response to a first active edge (low-to-high transition or high-to-low transition depending on whether the clock signal 208 is active high or active low, respectively) of the clock signal 208, the disable circuit 202 is triggered to deactivate the test mode enabling signal 108. Once deactivation of the test mode enabling signal 108 is triggered by the first active edge of the clock signal 208, the disable circuit 202 is able to maintain the test mode enabling signal 108 deactivated, until the reset signal 118 is activated, as discussed further below.

In response to the logic chip 100 being in the test mode, the clock gate 206 disables passing the clock signal 208 to the clock input 204 of the disable circuit 202. Instead, the clock gate 206 deactivates the clock input 204 of the disable circuit 202. If the clock input 204 of the disable circuit 202 is inactive (which means that the logic chip 100 has entered the test mode), then the disable circuit 202 is unable to change state and instead maintains the test mode enabling signal 108 at its previous state (which would be the active state once the logic chip 100 has entered the test mode). In other words, the disable circuit 202 maintains the test mode enabling signal 108 active while the logic chip 100 is in the test mode.

Before the logic chip 100 can enter the test mode from the functional mode, the logic chip 100 has to satisfy a specified condition where sensitive information in the storage element 116 is rendered inaccessible, such as due to a reset. As further shown in Fig. 2, the reset input 205 of the disable circuit 202 receives the reset signal 118. In response to activation of the reset signal 118, the disable circuit 202 is reset, which causes the disable circuit 202 to activate the test mode enabling signal 108, to enable the transition of the logic chip 100 from the functional mode to the test mode.

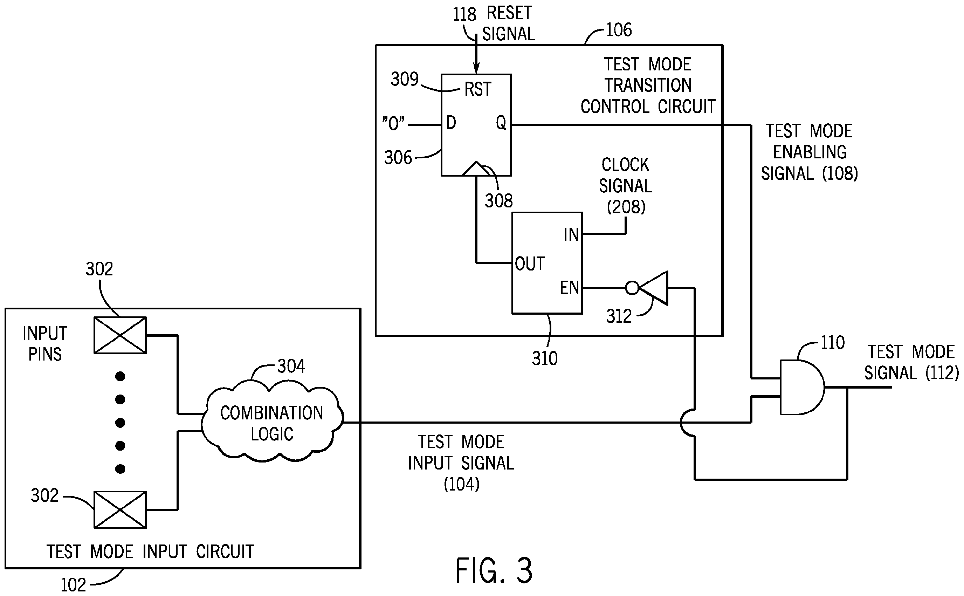

Fig. 3 is a block diagram of further details associated with the test mode input circuit 102 and the test mode transition control circuit 106, according to further examples of the present disclosure. The test mode input circuit 102 includes multiple input pins 302 and a combination logic 304, which can include a combination of logic gates configured to receive a value provided to the input pins 302. In response to a specified value provided to the input pins 302, the combination logic 304 asserts the test mode input signal 104 to an active state. In other examples, instead of multiple input pins 302, the test mode input circuit 102 can include just one input pin that is set to a value to indicate that the logic chip 100 is to enter the test mode.

The test mode transition control circuit 106 includes a D flip-flop 306, which is a latch that has a data input (D) and a data output (Q). The D flip-flop 306 is an example of the disable circuit 202 of Fig. 2. In other examples, the disable circuit 202 can be implemented with different logic. In the example of Fig. 3, the D input of the D flip-flop 306 receives a binary "0" value (which is an example of an inactive value). When the clock input 308 of the D flip-flop 306 receives an active clock signal, the D flip-flop 306 drives the Q output to the value received at the D input, which in this case is the binary "0" value. The Q output of the D flip-flop 306 is driven to the value at the D input with each cycle of the input clock signal received at the clock input 308. Note that once the Q output of the D flip-flop 306 has been set to the binary "0" value of the D input in response to an active clock signal, the D flip-flop 306 maintains the binary "0" value at the Q output, even if no further clock edges of the clock signal are received (in other words, the clock signal is deactivated).

The clock input 308 of the D flip-flop 306 is connected to the output of a clock gate 310, which is an example of the clock gate 206 in Fig. 2. The clock gate 310 has an input to receive the clock signal 208, and an enable input (EN) connected to an enable signal output from an inverter 312. The input of the inverter 312 is connected to the output of the logic AND gate 110, or more specifically, to the test mode signal 112. When the test mode signal 112 is in an inactive state, which indicates that the logic chip 100 is in the functional mode, then the enable signal provided to the EN input of the clock gate 310 is active, which allows the clock signal 208 to pass through the clock gate 310 to the clock input 308 of the D flip-flop 306, and which causes the D flip-flop 306 to set the Q output to the value received at the D input. This causes the test mode enabling signal 108 to be deactivated to the inactive state, which prevents activation of the test mode signal 112 and thus prevents a transition of the logic chip 100 to the test mode. Once the D flip-flop 306 drives its Q output (and thus the test mode enabling signal 108) to an inactive state in response to an active edge of the clock signal 208, the D flip-flop maintains the Q output at the inactive state until a reset occurs.

The D flip-flop 306 also has a reset input 309 to receive the reset signal 118. Activation of the reset signal 118 causes the D flip-flop 306 to be reset to binary "1" value, for example, which causes the test mode enabling signal 108 to be activated to the active state. As a result, the logic AND gate 110 is allowed to activate the test mode signal 112 in response to the test mode input signal 104 being set to the active state by the test mode input circuit 102.

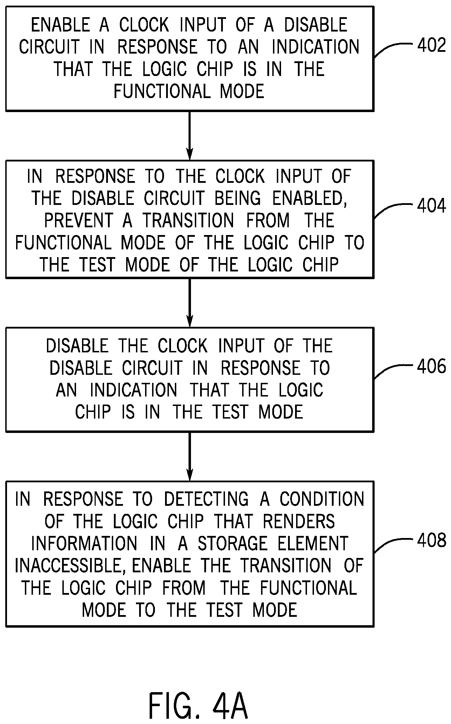

Fig. 4A is a flow diagram of an example process that can be performed in a logic chip, such as the logic chip 100 of Fig. 1, to control a transition between a functional mode and a test mode of the logic chip. The process of Fig. 4A can be performed by the test mode transition control circuit 106 of Fig. 1, for example. An example of the test mode transition control circuit 106 is depicted in Fig. 2. In other examples, the test mode transition control circuit 106 can have a different implementation, such as an implementation that includes a combination of a hardware processing circuit and machine-readable instructions executable on the hardware processing circuit.

The process of Fig. 4A includes enabling (at 402) a clock input to a disable circuit (e.g. the disable circuit 202 in Fig. 2) in response to an indication that the logic chip is in the functional mode (e.g. the test mode signal 112 of Fig. 1 is in an inactive state). In response to the clock input to the disable circuit being enabled, the process of Fig. 4A prevents (at 404) a transition from the functional mode of the logic chip to the test mode of the logic chip. In some examples, as discussed above, the transition of the logic chip from the functional mode to the test mode is prevented by deactivating a test mode enabling signal (e.g. 108 in Fig. 1, 2, or 3). Deactivation of the test mode enabling signal is triggered in response to an first active edge of a clock signal (e.g. 208 in Fig. 2 or 3) that is provided to the clock input of the disable circuit. Once deactivation of the test mode enabling signal 108 is triggered by the first active edge of the clock signal 208, the disable circuit 202 is able to maintain the test mode enabling signal 108 deactivated, until a reset or other condition that renders information in a storage element inaccessible occurs.

The process of Fig. 4A disables (at 406) the clock input of the disable circuit in response to an indication that the logic chip is in the test mode (e.g. the test mode signal 112 of Fig. 1 is in an active state). In response to detecting a condition of the logic chip that renders information in a storage element inaccessible (such as when the reset signal 118 is activated), the process of Fig. 4A enables (at 408) the transition of the logic chip from the functional mode to the test mode.

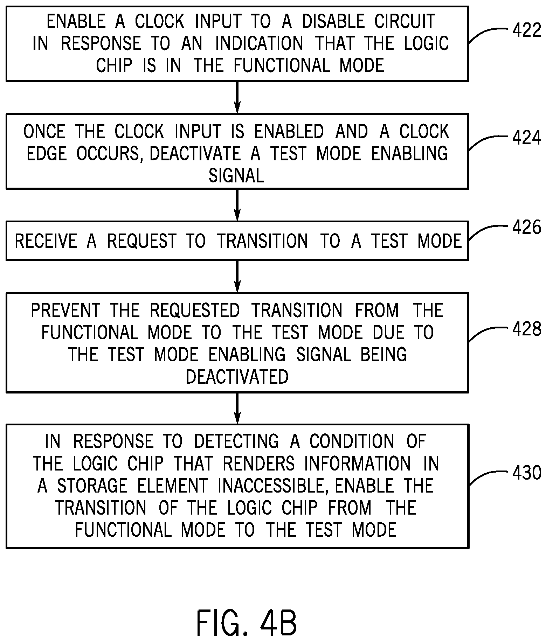

Fig. 4B is a flow diagram of another example process that can be performed in a logic chip, such as the logic chip 100 of Fig. 1, to control a transition between a functional mode and a test mode of the logic chip, according to further implementations. The process of Fig. 4B enables (at 422) a clock input to a disable circuit (e.g. the disable circuit 202 in Fig. 2) in response to an indication that the logic chip is in the functional mode. Once the clock input is enabled and a clock edge occurs, the process of Fig. 4B deactivates (at 424) a test mode enabling signal (e.g. 108 in Fig. 1, 2, or 3).

The process of Fig. 4B receives (at 426) a request to transition to a test mode, such as in response to the input pins 302 being set to a predefined value. The process of Fig. 4B prevents (at 428) the requested transition from the functional mode to the test mode due to the test mode enabling signal being deactivated. In response to detecting a condition of the logic chip that renders information in a storage element inaccessible (such as when the reset signal 118 is activated), the process of Fig. 4B enables (at 430) the transition of the logic chip from the functional mode to the test mode.

In examples where the test mode transition control circuit 106 is implemented as a combination of a hardware processing circuit and machine-readable instructions, the machine-readable instructions can be stored in a non-transitory machine-readable or computer-readable storage medium, which can include one or multiple different forms of memory including semiconductor memory devices such as dynamic or static random access memories (DRAMs or SRAMs), erasable and programmable read-only memories (EPROMs), electrically erasable and programmable read-only memories (EEPROMs) and flash memories; magnetic disks such as fixed, floppy and removable disks; other magnetic media including tape; optical media such as compact disks (CDs) or digital video disks (DVDs); or other types of storage devices. Note that the instructions discussed above can be provided on one computer-readable or machine-readable storage medium, or alternatively, can be provided on multiple computer-readable or machine-readable storage media distributed in a large system having possibly plural nodes. Such computer-readable or machine-readable storage medium or media is (are) considered to be part of an article (or article of manufacture). An article or article of manufacture can refer to any manufactured single component or multiple components. The storage medium or media can be located either in the machine running the machine-readable instructions, or located at a remote site from which machine-readable instructions can be downloaded over a network for execution.

In the foregoing description, numerous details are set forth to provide an understanding of the subject disclosed herein. The scope of the invention is defined by the appended claims.

## Claims

1. A method of controlling a transition between a functional mode and a test mode of a logic chip, comprising:
enabling (402) a clock input of a disable circuit in response to an indication that the logic chip is in the functional mode;
in response to the clock input of the disable circuit being enabled, preventing (404) a transition from the functional mode of the logic chip to the test mode of the logic chip;
disabling (406) the clock input of the disable circuit in response to an indication that the logic chip is in the test mode; and **characterized by**
in response to detecting a condition of the logic chip that renders information in a storage element inaccessible, enabling (408) the transition of the logic chip from the functional mode to the test mode.

2. The method of claim 1, wherein detecting the condition comprises receiving activation of a reset signal to reset the logic chip.

3. The method of claim 2, further comprising resetting the disable circuit in response to the activation of the reset signal.

4. The method of claim 3, wherein resetting the disable circuit causes the disable circuit to activate a first signal input to a logic gate that further receives a second signal that when activated indicates that the logic chip is to enter the test mode.

5. The method of claim 4, further comprising:
in response to an active edge of the clock input to the disable circuit, setting the first signal to an inactive state.

6. The method of claim 5, further comprising:
while the clock input to the disable circuit is disabled, maintaining the first signal at a previous state.

7. The method of claim 4, further comprising:
activating, by the logic gate, a test mode signal in response to both the first and second signals being active, wherein the activated test mode signal is an indication of the logic chip being in the test mode.

8. The method of claim 7, further comprising:
performing, by a test mode controller, a test operation in response to the activating of the test mode signal, the test mode operation comprising accessing a content in the storage element.

9. The method of claim 4, further comprising:
activating the second signal in response to at least one input pin of the logic chip being set to a predefined value.

10. A test mode transition control circuit (106) for a logic chip (100), comprising:
a disable circuit (202) comprising a clock input;
a clock gate (206) to:
enable passing a clock signal (208) to the clock input (204) of the disable circuit in response to the logic chip being in a functional mode, and
disable passing the clock signal to the clock input of the disable circuit in response to the logic chip being in a test mode; **characterized in that**
the disable circuit to deactivate a test mode enabling signal (108) in response to the clock input of the disable circuit receiving the clock signal through the clock gate, wherein the deactivated test mode enabling signal prevents a transition of the logic chip from the functional mode to the test mode, and
the disable circuit to activate the test mode enabling signal in response to a reset of the logic chip.

11. The test mode transition control circuit (106) of claim 10, wherein the disable circuit (202) comprises a D flip-flop (306) that has an input set to an inactive value, wherein an output of the D flip-flop is driven to the inactive value responsible to each cycle of the clock signal (208).

12. The test mode transition control circuit (106) of claim 10, wherein the disable circuit (202) is to maintain the test mode enabling signal (108) active while the logic chip (100) is in the test mode.

13. The test mode transition control circuit (106) of claim 10, wherein the clock gate (206) comprises:
an enable input to receive an enable signal that when in an active state indicates that the logic chip is in the functional mode, and when in an inactive state indicates that the logic chip is in the test mode, and
an input to receive the clock signal, the clock gate to pass the clock signal through the clock gate responsive to the enable signal being in the active state.

14. A logic chip (100) comprising:
the test mode transition control circuit (106) of claim 10;
a test mode input circuit (102) to activate a test mode input signal in response to an input to request that the logic chip be placed in a test mode;
wherein the clock input is enabled in response to an indication that the logic chip is in a functional mode, and that is disabled in response to an indication that the logic chip is in the test mode, the disable circuit to, once the clock input of the disable circuit is enabled and a clock edge occurs, deactivate the test mode enabling signal to prevent a transition of the logic chip from the functional mode to the test mode, and the disable circuit to activate the test mode enabling signal in response to detecting a reset of the logic chip;
a logic gate (110) to cause the logic chip to enter the test mode in response to the test mode input signal being activated and the test mode enabling signal being activated; and
a test controller (114) to perform a test operation during the test mode.

15. The logic chip (100) of claim 14, further comprising a storage element (116) to store sensitive information during the functional mode of the logic chip, wherein the reset renders the sensitive information in the storage element inaccessible.

## Patentansprüche

1. Verfahren zum Steuern eines Übergangs zwischen einem Funktionsmodus und einem Testmodus eines Logikchips, das Folgendes umfasst:
Freigeben (402) eines Takteingangs einer Sperrschaltung als Reaktion auf eine Anzeige, dass sich der Logikchip in dem Funktionsmodus befindet;
als Reaktion darauf, dass der Takteingang der Sperrschaltung freigegeben ist, Verhindern (404) eines Übergangs von dem Funktionsmodus des Logikchips in den Testmodus des Logikchips;
Sperren (406) des Takteingangs der Sperrschaltung als Reaktion auf eine Anzeige, dass sich der Logikchip in dem Testmodus befindet; und **gekennzeichnet durch**
als Reaktion auf ein Erfassen eines Zustands des Logikchips, der Informationen in einem Speicherelement unzugänglich macht, Freigeben (408) des Übergangs des Logikchips von dem Funktionsmodus in den Testmodus.

2. Verfahren nach Anspruch 1, wobei das Erfassen des Zustands ein Empfangen einer Aktivierung eines Rücksetzsignals umfasst, um den Logikchip rückzusetzen.

3. Verfahren nach Anspruch 2, das ferner das Rücksetzen der Sperrschaltung als Reaktion auf die Aktivierung des Rücksetzsignals umfasst.

4. Verfahren nach Anspruch 3, wobei das Rücksetzen der Sperrschaltung veranlasst, dass die Sperrschaltung einen ersten Signaleingang in einem Logikgatter aktiviert, das ferner ein zweites Signal empfängt, das, wenn es aktiviert ist, anzeigt, dass der Logikchip dazu dient, in den Testmodus einzutreten.

5. Verfahren nach Anspruch 4, das ferner Folgendes umfasst:
als Reaktion auf eine aktive Flanke des Takteingangs in die Sperrschaltung, Einstellen des ersten Signals in einen inaktiven Zustand.

6. Verfahren nach Anspruch 5, das ferner Folgendes umfasst:
während der Takteingang in die Sperrschaltung gesperrt ist, Halten des ersten Signals in einem vorherigen Zustand.

7. Verfahren nach Anspruch 4, das ferner Folgendes umfasst:
Aktivieren, durch das Logikgatter, eines Testmodussignals als Reaktion darauf, dass sowohl das erste als auch das zweite Signal aktiv ist, wobei das aktivierte Testmodussignal eine Anzeige ist, dass sich der Logikchip in dem Testmodus befindet.

8. Verfahren nach Anspruch 7, das ferner Folgendes umfasst:
Durchführen, durch eine Testmodussteuerung, eines Testbetriebs als Reaktion auf das Aktivieren des Testmodussignals, wobei der Testmodusbetrieb das Zugreifen auf einen Inhalt in dem Speicherelement umfasst.

9. Verfahren nach Anspruch 4, das ferner Folgendes umfasst:
Aktivieren des zweiten Signals als Reaktion darauf, dass wenigstens ein Eingangsstift des Logikchips auf einen vordefinierten Wert eingestellt ist.

10. Testmodusübergangssteuerschaltung (106) für einen Logikchip (100), die Folgendes umfasst:
eine Sperrschaltung (202), die einen Takteingang umfasst;
ein Taktgatter (206) für Folgendes:
Freigeben des Weiterleitens eines Taktsignals (208) an den Takteingang (204) der Sperrschaltung als Reaktion darauf, dass sich der Logikchip in einem Funktionsmodus befindet, und
Sperren des Weiterleitens des Taktsignals an den Takteingang der Sperrschaltung als Reaktion darauf, dass sich der Logikchip in einem Testmodus befindet; **dadurch gekennzeichnet, dass**
die Sperrschaltung ein Testmodusfreigabesignal (108) als Reaktion darauf deaktiviert, dass der Takteingang der Sperrschaltung das Taktsignal durch das Taktgatter empfängt, wobei das deaktivierte Testmodusfreigabesignal einen Übergang des Logikchips von dem Funktionsmodus in den Testmodus verhindert und
wobei die Sperrschaltung das Testmodusfreigabesignal als Reaktion auf ein Rücksetzen des Logikchips freigibt.

11. Testmodusübergangssteuerschaltung (106) nach Anspruch 10, wobei die Sperrschaltung (202) ein D-Flip-Flop (306) umfasst, das einen Eingang aufweist, der auf einen inaktiven Wert eingestellt ist, wobei ein Ausgang des D-Flip-Flops auf den inaktiven Wert getrieben wird, der für jeden Zyklus des Taktsignals (208) verantwortlich ist.

12. Testmodusübergangssteuerschaltung (106) nach Anspruch 10, wobei die Sperrschaltung (202) dazu dient, das Testmodusfreigabesignal (108) aktiv zu halten, während sich der Logikchip (100) in dem Testmodus befindet.

13. Testmodusübergangssteuerschaltung (106) nach Anspruch 10, wobei das Taktgatter (206) Folgendes umfasst:
einen Freigabeeingang, um ein Freigabesignal zu empfangen, das, wenn es sich in einem aktiven Zustand befindet, anzeigt, dass sich der Logikchip in dem Funktionsmodus befindet, und wenn es sich in einem inaktiven Zustand befindet, anzeigt, dass sich der Logikchip in dem Testmodus befindet, und
einen Eingang, um das Taktsignal zu empfangen, wobei das Taktgatter das Taktsignal durch das Taktgatter weiterleitet, reagierend darauf, dass sich das Freigabesignal in dem aktiven Zustand befindet.

14. Logikchip (100), der Folgendes umfasst:
die Testmodusübergangssteuerschaltung (106) nach Anspruch 10;
eine Testmoduseingangsschaltung (102), um ein Testmoduseingangssignal als Reaktion auf einen Eingang zu aktivieren, um anzufordern, dass der Logikchip in einen Testmodus versetzt wird;
wobei der Takteingang als Reaktion auf eine Anzeige, dass sich der Logikchip in einem Funktionsmodus befindet, freigegeben wird, und der als Reaktion auf eine Anzeige, dass sich der Logikchip in dem Testmodus befindet, gesperrt wird, die Sperrschaltung, sobald der Takteingang der Sperrschaltung freigegeben ist und eine Taktflanke auftritt, das Testmodusfreigabesignal deaktiviert, um einen Übergang des Logikchips von dem Funktionsmodus in den Testmodus zu verhindern, und die Sperrschaltung das Testmodusfreigabesignal als Reaktion auf das Erfassen eines Rücksetzens des Logikchips aktiviert;
ein Logikgatter (110), um zu veranlassen, dass der Logikchip als Reaktion darauf, dass das Testmoduseingangssignal aktiviert wird und das Testmodusfreigabesignal aktiviert wird, in den Testmodus eintritt; und
eine Teststeuerung (114), um einen Testbetrieb während des Testmodus durchzuführen.

15. Logikchip (100) nach Anspruch 14, der ferner ein Speicherelement (116) umfasst, um sensible Informationen während des Funktionsmodus des Logikchips zu speichern, wobei das Rücksetzen die sensiblen Informationen in dem Speicherelement unzugänglich macht.

## Revendications

1. Procédé de commande d'une transition entre un mode fonctionnel et un mode de test d'une puce logique, comprenant :
l'activation (402) d'une entrée d'horloge d'un circuit de désactivation en réponse à une indication que la puce logique est dans le mode fonctionnel ;
en réponse à l'activation de l'entrée d'horloge du circuit de désactivation, l'empêchement (404) d'une transition du mode fonctionnel de la puce logique vers le mode de test de la puce logique ;
la désactivation (406) de l'entrée d'horloge du circuit de désactivation en réponse à une indication selon laquelle la puce logique est dans le mode de test ; et **caractérisé par**
en réponse à la détection d'une condition de la puce logique qui rend les informations dans un élément de stockage inaccessibles, l'activation (408) de la transition de la puce logique du mode fonctionnel vers le mode de test.

2. Procédé selon la revendication 1, dans lequel la détection de la condition comprend la réception de l'activation d'un signal de réinitialisation pour réinitialiser la puce logique.

3. Procédé selon la revendication 2, comprenant en outre la réinitialisation du circuit de désactivation en réponse à l'activation du signal de réinitialisation.

4. Procédé selon la revendication 3, dans lequel la réinitialisation du circuit de désactivation amène le circuit de désactivation à activer une première entrée de signal sur une porte logique qui reçoit en outre un second signal qui, lorsqu'il est activé, indique que la puce logique doit entrer dans le mode de test.

5. Procédé selon la revendication 4, comprenant en outre :
en réponse à un front actif de l'entrée d'horloge du circuit de désactivation, le réglage du premier signal à un état inactif.

6. Procédé selon la revendication 5, comprenant en outre :
tandis que l'entrée d'horloge du circuit de désactivation est désactivée, le maintien du premier signal à un état précédent.

7. Procédé selon la revendication 4, comprenant en outre :
l'activation, par la porte logique, d'un signal de mode de test en réponse à la fois aux premier et second signaux étant actifs, le signal de mode de test activé étant une indication selon laquelle la puce logique est dans le mode de test.

8. Procédé selon la revendication 7, comprenant en outre :
la réalisation, par un dispositif de commande de mode de test, d'une opération de test en réponse à l'activation du signal de mode de test, l'opération de mode de test comprenant l'accès à un contenu dans l'élément de stockage.

9. Procédé selon la revendication 4, comprenant en outre :
l'activation du second signal en réponse au fait qu'au moins une broche d'entrée de la puce logique est réglée sur une valeur prédéfinie.

10. Circuit de commande de transition de mode de test (106) pour une puce logique (100), comprenant :
un circuit de désactivation (202) comprenant une entrée d'horloge ;
une porte d'horloge (206) pour :
activer le passage d'un signal d'horloge (208) à l'entrée d'horloge (204) du circuit de désactivation en réponse au fait que la puce logique est dans un mode fonctionnel, et
désactiver le passage du signal d'horloge à l'entrée d'horloge du circuit de désactivation en réponse au fait que la puce logique est dans un mode de test ;
**caractérisé en ce que**
le circuit de désactivation pour désactiver un signal d'activation de mode de test (108) en réponse à l'entrée d'horloge du circuit de désactivation recevant le signal d'horloge à travers la porte d'horloge, le signal d'activation de mode de test désactivé empêchant une transition de la puce logique du mode fonctionnel vers le mode de test, et
le circuit de désactivation pour activer le signal de validation de mode de test en réponse à une réinitialisation de la puce logique.

11. Circuit de commande de transition de mode de test (106) selon la revendication 10, dans lequel le circuit de désactivation (202) comprend une bascule bistable D (306) qui a une entrée réglée sur une valeur inactive, dans lequel une sortie de la bascule bistable D est commandée à la valeur inactive responsable de chaque cycle du signal d'horloge (208).

12. Circuit de commande de transition de mode de test (106) selon la revendication 10, dans lequel le circuit de désactivation (202) doit maintenir le signal d'activation de mode de test (108) actif tandis que la puce logique (100) est dans le mode de test.

13. Circuit de commande de transition de mode de test (106) selon la revendication 10, dans lequel la porte d'horloge (206) comprend :
une entrée d'activation pour recevoir un signal d'activation qui, lorsqu'elle est dans un état actif, indique que la puce logique est dans le mode fonctionnel, et lorsqu'elle est dans un état inactif, indique que la puce logique est dans le mode de test, et
une entrée pour recevoir le signal d'horloge, la porte d'horloge pour faire passer le signal d'horloge à travers la porte d'horloge en réponse au fait que le signal d'activation est dans l'état actif.

14. Puce logique (100) comprenant :
le circuit de commande de transition de mode de test (106) selon la revendication 10;
un circuit d'entrée de mode de test (102) pour activer un signal d'entrée de mode de test en réponse à une entrée pour demander que la puce logique soit placée dans un mode de test ;
dans lequel l'entrée d'horloge est activée en réponse à une indication que la puce logique est dans un mode fonctionnel, et qui est désactivée en réponse à une indication que la puce logique est en mode de test, le circuit de désactivation pour, une fois que l'entrée d'horloge du circuit de désactivation est activé et un front d'horloge se produit, désactiver le signal d'activation de mode de test pour empêcher une transition de la puce logique du mode fonctionnel vers le mode de test, et le circuit de désactivation pour activer le signal d'activation de mode de test en réponse à la détection d'une réinitialisation de la puce logique ;
une porte logique (110) pour amener la puce logique à entrer dans le mode dectest en réponse à l'activation du signal d'entrée de mode de test et à l'activation du signal d'activation de mode de test ; et
un dispositif de commande de test (114) pour effectuer une opération de test pendant le mode de test.

15. Puce logique (100) selon la revendication 14, comprenant en outre un élément de stockage (116) pour stocker des informations sensibles pendant le mode fonctionnel de la puce logique, dans laquelle la réinitialisation rendent les informations sensibles dans l'élément de stockage inaccessibles.
